# EUROPÄISCHE PATENTSCHRIFT

(11) **EP 3 170 378 B1**
(45) Veröffentlichungstag und Bekanntmachung des Hinweises auf die Patenterteilung: **17.04.2019**
(21) Anmeldenummer: 15777916.6
(22) Anmeldetag: 05.10.2015
(51) Int. Cl.: H05K 13/08

(54) **BESTÜCKEN VON LEITERPLATTEN**
POPULATION OF PRINTED CIRCUIT BOARDS
ÉQUIPEMENT DE CARTES À CIRCUIT IMPRIMÉ

(30) Priorität: 11.11.2014 DE 102014222940
(43) Veröffentlichungstag der Anmeldung: 24.05.2017
(73) Patentinhaber: Siemens Aktiengesellschaft, 80333 München (DE)
(72) Erfinder: PFAFFINGER, Alexander, 81739 München (DE); ROYER, Christian, 85521 Ottobrunn (DE)
(86) Internationale Anmeldenummer: PCT/EP2015/072898
(87) Internationale Veröffentlichungsnummer: WO 2016/074857

(56) Entgegenhaltungen:
- EP-A1- 0 478 360
- EP-A1- 0 478 361
- WO-A1-2014/005742
- DE-A1- 19 834 620

## Beschreibung

Die vorliegende Erfindung betrifft ein Verfahren und ein System zur Bestückung von Leiterplatten. Dabei wird eine Bestückungslinie vorausgesetzt, die dazu eingerichtet ist, Leiterplatten mit Bauelementen zu bestücken.

Eine elektronische Baugruppe umfasst eine Leiterplatte und Bauelemente, die auf ihr mechanisch und elektrisch befestigt sind. Zur Herstellung der Leiterplatte werden die Bauelemente mittels eines Bestückungsautomaten (pick-and-place) auf der Leiterplatte abgelegt und anschließend in einem Reflow-Ofen mit ihr verlötet. Mehrere Bestückungsautomaten können auf einer Bestückungslinie nacheinander durchlaufen werden. Zur Herstellung vieler Leiterplatten kann ein Bestückungssystem verwendet werden, das mehrere Bestückungslinien umfasst.

An einer Bestückungslinie sind Vorräte von Bauelementen vorbestimmter Bauelementetypen auf Rüsttischen angebracht. Soll eine Leiterplatte bestückt werden, für die nicht alle Bauelemente an einem der angebrachten Rüsttische vorhanden sind, so werden die Rüsttische gegen andere Rüsttische ausgetauscht, die dazu mit den benötigten Bauelementen ausgestattet wurden. Die Zahl der verfügbaren Rüsttische ist üblicherweise begrenzt und das Ausstatten eines Rüsttischs mit Bauelementen eines Bauelementetyps kann aufwändig sein. Es kann daher eine Festrüstung gebildet werden, die auf einem oder mehreren Rüsttischen über einen längeren Planungshorizont hinweg unverändert angebracht bleibt.

DE 10 2012 220 904 A1 betrifft ein Verfahren zur Bestimmung einer Festrüstung für eine Bestückungslinie.

EP 0 478 360 A1 betrifft ein Verfahren zur Bestückung unterschiedlicher Leiterplatten mit einer Bestückungsmaschine, bei dem zur Festlegung der Rüstung der Maschine mit unterschied lichen Bauteiltypen der "greedy-board"-Algorithmus verwendet wird. Dabei wird für jeden Leiterplattentyp das Verhältnis aus der zur Bestückung des betreffenden Leiterplattentyps benötigten Anzahl unterschiedlicher Bauteiltypen zu gewünschter Fertigungszahl bestimmt. Die Bauteiltypen, die zur Bestückung der Leiterplatte mit dem kleinsten ermittelten Verhältnis benötigt werden, werden dauerhaft an der Maschine bereitgestellt. Die Bauteiltypen für die übrigen Leiterplattentypen werden abhängig von dem ermittelten Verhältnis in verschiedene Gruppen zur wechselbaren Rüstung der Maschine eingeteilt.

DE 198 34 620 A1 betrifft ein Verfahren zur Ermittlung einer Rüstung einer Bestückungslinie für Leiterplatten. Es werden Festrüstungen ermittelt. Übersteigt die Anzahl unterschiedlicher Bauelementetypen einer Festrüstung die Rüstkapazität der Linie, werden die am häufigsten verwendeten Bauteiltypen fest an der Maschine vorgehalten und die restlichen je nach Bedarf nachgerüstet.

EP 0 478 361 A1 betrifft ein Verfahren zur Bestimmung von Rüstungen einer Bestückungsmaschine für Leiterplatten, bei welchem die Rüst- und Bestückungskosten minimiert werden. Dabei werden alternativ der "greedy board"-Algorithmus oder der "stingy component"-Algorithmus verwendet. Bei Letzterem wird zunächst eine Rüstung mit allen Bauteiltypen erstellt. Übersteigt die Rüstung die Kapazität der Maschine, werden solange die Bauteiltypen mit den geringsten Rüstkosten entfernt, bis die Kapazität der Maschine die Rüstung umfassen kann.

WO 2014/005742 A1 betrifft ein Verfahren zur Bildung von Rüstfamilien einer Bestückungslinie für Leiterplatten. Dabei werden zunächst Rüstfamilien auf Grundlage des "greedy board"-Algorithmus bestimmt. Anschließend wird die Anzahl der bestimmten Rüstfamilien iterativ verringert, indem die Bauteile einer Rüstfamilie auf die anderen Rüstfamilien aufgeteilt werden.

Im Sinne einer guten Auslastung der Bestückungslinie ist es von entscheidender Bedeutung, die Festrüstung möglichst so zu bestimmen, dass Variantenrüstungen, denen die verbleibenden Bauelementetypen vorgegebener Bestückungsaufträge zugeordnet werden, effizient an der Bestückungslinie gerüstet werden können. Der Erfindung liegt die Aufgabe zu Grunde, eine verbesserte Technik zur verbesserten Bestückung von Leiterplatten anzugeben. Die Erfindung löst die Aufgabe mittels der Gegenstände der unabhängigen Ansprüche. Unteransprüche geben bevorzugte Ausführungsformen wieder.

An einer Bestückungslinie ist eine Rüstung bereitgestellt, wobei der Rüstung eine Rüstfamilie zugeordnet ist, die mehrere Leiterplattentypen umfasst und wobei der Rüstung Bauelementetypen zugeordnet sind, sodass eine Leiterplatte eines Leiterplattentyps einer Rüstfamilie mittels Bauelementen der Bauelementetypen der Rüstung bestückt werden kann. Dazu ist ein erster Planungszeitraum vorgegeben, der in mehrere zweite Planungszeiträume aufgeteilt ist. Jede Rüstung kann durch Bereitstellen von Vorräten von Bauelementen der zugeordneten Bauelementetypen auf einem oder mehreren Rüsttischen realisiert werden kann. Dabei werden die Rüstungen in Festrüstungen und Variantenrüstungen unterschieden, wobei eine Festrüstung dazu eingerichtet ist, über den ersten Planungszeitraum unverändert auf einem oder mehreren Rüsttischen realisiert zu bleiben, und eine Variantenrüstung dazu, innerhalb eines zweiten Planungszeitraums nur vorübergehend an einem oder mehreren Rüsttischen realisiert zu werden.

Ein Verfahren zum Bestücken von Leiterplatten mittels einer Bestückungslinie umfasst Schritte (a) des Erfassens von Aufträgen, jeweils zur Bestückung einer Stückzahl von Leiterplatten eines Leiterplattentyps mit Bauelementen zugeordneter Bauelementetypen in einem vorbestimmten zweiten Planungszeitraum, (b) des Zuordnens von Bauelementetypen zu Festrüstungen auf der Basis aller Aufträge, (c) des Optimierens der Zuordnung bezüglich der Maximierung einer gewichteten Kombination eines Produktionsvolumens und einer Auftragszahl, (d) des Durchführens, für jeden zweiten Planungszeitraum, eines Zuordnens von Bauelementetypen zu Variantenrüstungen auf der Basis von Aufträgen des jeweiligen zweiten Planungszeitraums und des Bestimmens einer Abfolge, in der Festrüstungen oder Variantenrüstungen an der Bestückungslinie gerüstet werden sollen, um jeweils einen Auftrag zu bearbeiten; ferner (e) des Bestimmens eines Kriteriums, das die Qualitäten der bestimmten Abfolgen aller zweiten Planungszeiträume umfasst, (f) des Wiederholens der Schritte (b) bis (e) unter einer veränderten Gewichtung der Kombination, (g) des Bestimmens einer optimierten Gewichtung, bei der das Kriterium optimiert ist, und (h) des Bestückens von Leiterplatten mittels einer Rüstung, die auf der Basis der optimierten Gewichtung bestimmt wurde.

Durch das Verfahren kann insbesondere bestimmt werden, welche Gewichtung es erlaubt, eine Festrüstung für die Bestückungslinie zu bestimmen, die zu Variantenrüstungen führt, die gut an der Bestückungslinie zu handhaben sind. Dies kann beispielsweise nützlich sein, um eine Festrüstung für einen nachfolgenden ersten Planungszeitraum zu bestimmen, für den noch nicht alle Aufträge bekannt sind. So kann auf der Basis von historischen oder statistischen Auftragsdaten eine Festrüstung bestimmt werden, die mit hoher Wahrscheinlichkeit wieder zu gut handhabbaren Variantenrüstungen führt. Erfindungsgemäß wurde erkannt, dass die Optimierung der Zuordnung von Bauelementen zu der Festrüstung bezüglich der gewichteten Kombination des Produktionsvolumens und der Auftragszahl zu optimieren ist. Durch das Bestimmen der optimierten Gewichtung kann ein guter Kompromiss zwischen den beiden Zielkriterien gefunden werden, die einander unter bestimmten Umständen bezüglich der Bildung der Festrüstung widersprechen können.

Das Kriterium zur Beurteilung der Qualität der bestimmten Abfolgen in den zweiten Planungszeiträumen kann unterschiedlich gewählt werden. So kann das Kriterium an Anforderungen oder technische Gegebenheiten der Bestückungslinie oder der Aufträge angepasst werden.

In einer Ausführungsform umfasst das Kriterium die Minimierung einer Stillstandszeit. Die Stillstandszeit entsteht, wenn das Bestücken auf der Bestückungslinie mittels einer ersten Rüstung abgeschlossen ist, bevor eine in der Abfolge nachfolgende zweite Rüstung fertig realisiert ist. Anders ausgedrückt kann eine Stillstandszeit entstehen, wenn zum Realisieren der zweiten Rüstung zuvor nicht ausreichend Zeit blieb. Da Anschaffung und Betrieb der Bestückungslinie mit erheblichen Kosten verbunden sein können, ist die Vermeidung bzw. Minimierung von Stillstandszeiten von besonderem Interesse.

Das Produktionsvolumen kann zur Verringerung der Stillstandszeiten verstärkt gewichtet werden. Wird beispielsweise befunden, dass das Kriterium suboptimal ist, weil die Stillstandszeiten unbefriedigend lang sind, so kann die Gewichtung der Kombination gezielt in Richtung des Produktionsvolumens verschoben werden.

In einer weiteren Ausführungsform umfasst das Kriterium eine Minimierung einer Anzahl Variantenrüstungen. Je weniger Variantenrüstungen zu realisieren sind, desto geringer kann ein Rüstaufwand sein, sodass die Variantenrüstungen in eine verbesserte Abfolge gebracht werden können.

In einer Variante wird das Produktionsvolumen zur Verringerung der Anzahl Variantenrüstungen verringert gewichtet. Bevorzugterweise wird die Gewichtung des Produktionsvolumens nur so weit verringert, wie die Stillstandszeiten unterhalb einer zulässigen Schwelle bleiben. Diese Schwelle kann beispielsweise bei null liegen. In noch einer weiteren Ausführungsform umfasst das Kriterium die Minimierung einer Anzahl Rüstvorgänge. Dabei umfasst ein Rüstvorgang den Vorgang des Ausstattens wenigstens eines Rüsttischs mit einem Vorrat von Bauelementen eines Bauelementetyps, der einer Variantenrüstung zugeordnet ist. Je seltener Rüstvorgänge durchgeführt werden müssen, desto mehr Zeit kann für die Vorbereitung einer Rüstung zur Verfügung stehen.

In einer weiteren Ausführungsform umfasst das Kriterium die Minimierung einer Anzahl Rüstwechsel von einer ersten Rüstung auf eine zweite Rüstung an der Bestückungslinie.

In einer weiteren Ausführungsform kann das Kriterium auch eine gewichtete Kombination mehrerer der genannten Faktoren umfassen. Die erzielbaren Ergebnisse des Verfahrens können dadurch verbessert werden.

Weiterhin werden die Schritte b.) bis e.) wiederholt, bis das Kriterium eine vorbestimmte Qualität erreicht hat oder eine vorbestimmte Bearbeitungszeit abgelaufen ist. Konnte innerhalb der vorbestimmten Bearbeitungszeit keine akzeptable Qualität des Kriteriums erreicht werden, so kann die Akzeptanzschwelle für das Kriterium verändert oder ein Parameter, der die Laufzeit des Verfahrens beeinflusst, verändert werden. Beispielsweise kann die Ausstattung der Bestückungslinie verändert werden, um eine weitere Verbesserung des Kriteriums zuzulassen.

Die gewichtete Kombination kann auch erweitert werden. Insbesondere kann die Kombination um einen Bestandteil erweitert werden, der die Summe der Anzahl Bauelementetypen, die Festrüstungen zugeordnet sind, multipliziert mit der zugeordneten Auftragszahl, umfasst. Andere oder zusätzliche Bestandteile sind ebenfalls möglich.

Es ist besonders bevorzugt, dass wenigstens der Schritt c.) mittels eines Gemischt Ganzzahligen Programms erfolgt. Die Gemischt Ganzzahlige Programmierung kann unter Zuhilfenahme eines Computers für hochwertige Optimierungsergebnisse sorgen.

Ein Computerprogrammprodukt umfasst Programmcodemittel zur Durchführung des oben beschriebenen Verfahrens, wenn das Computerprogrammprodukt auf einer Verarbeitungseinrichtung abläuft.

Ein System zur Bestückung von Leiterplatten umfasst eine Bestückungslinie und eine Verarbeitungseinrichtung zur Durchführung des oben beschriebenen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
- Fig. 1: ein Bestückungssystem;
- Fig. 2: ein Ablaufdiagramm eines Verfahrens zur Bestimmung einer Festrüstung für die Bestückungslinie des Bestückungssystems von Fig. 1; und
- Fig. 3: eine exemplarische Abfolge von Rüstungen an einer Bestückungslinie des Bestückungssystems von Fig. 1
darstellt.

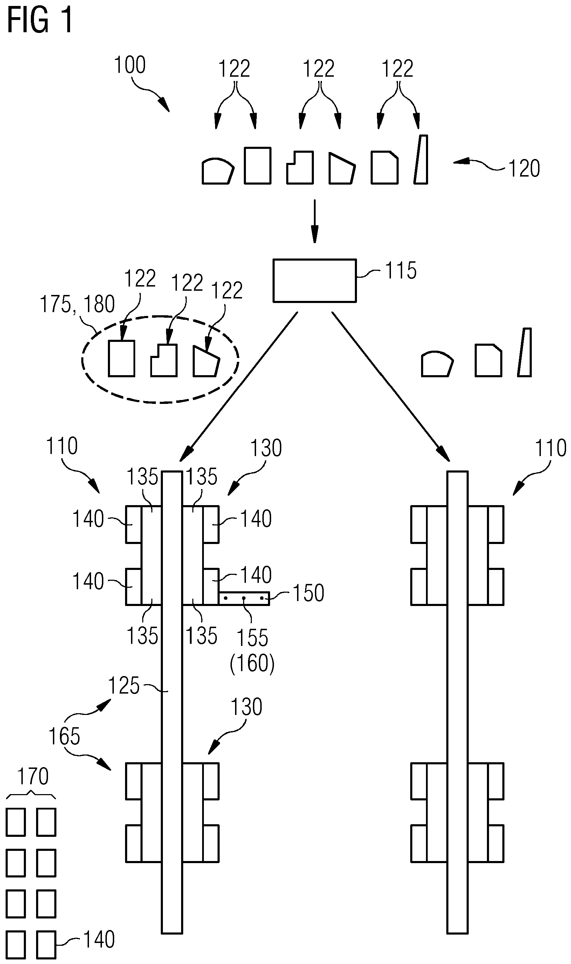

Figur 1 zeigt ein beispielhaftes Bestückungssystem 100. Das Bestückungssystem 100 umfasst eine oder mehrere Bestückungslinien 110 und eine Verarbeitungs- oder Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 ein Bauelement 155 aufzunehmen und an einer vorbestimmten Position auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen üblicherweise mehrere Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementetyps 160 sind üblicherweise bereitgestellt in einem Gurt, auf einem Tablett oder in einer Röhre.

Jeder Bauelementetyp 160 erfordert an der Zuführungseinrichtung 150 und am Rüsttisch 140 eine vorbestimmte Anzahl Spuren, die üblicherweise aneinander angrenzen. Die Anzahl der Bauelemente 155 eines Bauelementetyps 160 in einer Zuführungseinrichtung 150 wird hier vereinfachend als praktisch unendlich groß angesehen, sodass ein Nachrüsten nicht erforderlich ist. Gewöhnlich kann eine Zuführungseinrichtung 150 zur Bereithaltung von Bauelementen 155 unterschiedlicher Bauelementetypen 160 konfiguriert werden und üblicherweise können unterschiedliche Zuführungseinrichtungen 150 an einem Rüsttisch 140 angebracht werden.

Wird am Bestückungsautomaten 130 ein Bauelement 155 eines Bauelementetyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht.

Eine Rüstung 165, 170 umfasst eine Menge von Bauelementetypen 160 und wird realisiert mittels einem oder mehreren Rüsttischen 140, die jeweils mit Vorräten von Bauelementen 155 der Bauelementetypen 160 der Rüstung 165, 170 ausgestattet sind, um an der Bestückungslinie 110 angebracht zu werden. Dabei kann zwischen Festrüstungen 165 und Variantenrüstungen 170 unterschieden werden. Eine Festrüstung 165 ist dazu vorgesehen, auf dem oder den Rüsttischen 140 über einen vorbestimmten Planungshorizont unverändert gerüstet zu bleiben, während eine Variantenrüstung 170 dazu eingerichtet ist, auf einem oder mehreren Rüsttischen 140 innerhalb des Planungshorizonts nur vorübergehend gerüstet zu bleiben. Der Planungshorizont kann beispielsweise einen bis ca. 10 Tage betragen. Eine Zeit- über die eine Variantenrüstung 165 auf einem oder mehreren Rüsttischen 140 realisiert ist, ist üblicherweise wesentlich kürzer als der Planungshorizont. Diese Zeit kann beispielsweise mehrere Stunden oder Tage betragen, üblicherweise jedoch nicht länger als eine Woche.

Eine Rüstfamilie 175, 180 umfasst eine Anzahl Leiterplattentypen 122 und ist genau einer Rüstung 156, 170 zugeordnet und umgekehrt. Dabei kann zwischen einer Festrüstungs-Rüstfamilie 175 und einer Variantenrüstungs-Rüstfamilie 180 unterschieden werden. Eine Festrüstungs-Rüstfamilie 175 ist einer Festrüstung 165 zugeordnet und umfasst Leiterplattentypen 122, deren zugeordneten Leiterplatten 120 mit Bauelementen 155 von Bauelementetypen 160 der zugeordneten Festrüstung 165 vollständig bestückt werden können. Entsprechend ist eine Variantenrüstungs-Rüstfamilie 180 einer Variantenrüstung 170 zugeordnet und umfasst Leiterplattentypen 122, deren zugeordneten Leiterplatten 120 mit Bauelementen 155 von Bauelementetypen 160 der zugeordneten Variantenrüstung 170 vollständig bestückt werden können.

Im Betrieb der Bestückungslinie 110 werden nacheinander verschiedene Rüstungen 165, 170 an der Bestückungslinie 110 angebracht, um jeweils zugeordnete Leiterplatten 120 zu bestücken. Ein Wechsel von Rüstungen 165, 170 an der Bestückungslinie 110 wird Rüstwechsel genannt und bedingt üblicherweise einen Stillstand der Bestückungslinie 110.

Um eine Festrüstung 165 oder eine Variantenrüstung 170 zu realisieren werden üblicherweise einer oder mehrere Rüsttische 140, während sie nicht an der Bestückungslinie 110 angebracht sind, mit Vorräten von Bauelementen 155 vorbestimmter Bauelementetypen 160 aufgerüstet. Bereits aufgerüstete Bauelemente 155 nicht benötigter Bauelementetypen 160 können zuvor abgerüstet werden oder gerüstet bleiben. Dieser Vorgang wird Vorrüstung genannt und kann eine Bearbeitungszeit im Bereich von einer oder mehreren Stunden, beispielsweise ca. 6-10 Stunden, erfordern.

Um den mit einer Variantenrüstung 170 verbundenen Aufwand des Aufrüstens und Abrüstens sowie des Rüstwechsels zu minimieren wird üblicherweise versucht, möglichst viele Leiterplattentypen 122 in Festrüstungen 165 aufzunehmen. Ein angestrebter Fall ohne Variantenrüstungen 170 ist in der Praxis jedoch kaum erzielbar.

Für den Betrieb der Bestückungslinie 110 ist es entscheidend, wie die Rüstfamilien 175, 180 bzw. die Rüstungen 165, 170 zusammengesetzt sind. Bei deren Bildung können Nebenbedingungen zu beachten sein, beispielsweise die Einhaltung einer begrenzten Fassungskapazität eines Rüsttisches 140 für Bauelementetypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Bildung von Rüstfamilien 175, 180 bzw. Rüstungen 165, 170 bzw. Rüstungen kann mittels der Steuereinrichtung 115 erfolgen. Außerdem kann die Steuereinrichtung 115 eine Abfolge bestimmen, in der die Rüstungen 165, 170 an der Bestückungslinie 110 gerüstet werden sollen. Ferner kann die Steuereinrichtung 115 die Bestückung auf einer Bestückungslinie 110 oder dem ganzen Bestückungssystem 100 steuern.

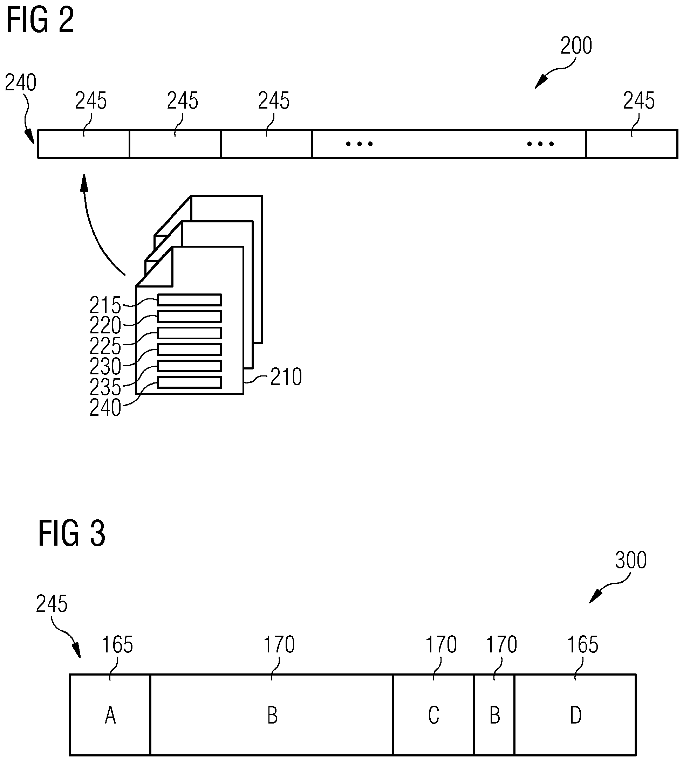

Figur 2 zeigt ein Ablaufdiagramm eines Verfahrens 200 zur Bestimmung einer Abfolge von Rüstungen an einer Bestückungslinie 110 des Bestückungssystems 100 von Fig. 1;

Zur Bestückung von Leiterplatten 120 eines Leiterplattentyps 122 auf einer Bestückungslinie liegt ein Auftrag 210 vor. Der Auftrag 210 umfasst üblicherweise wenigstens den Leiterplattentyp 122 und eine Stückzahl 215 der zu bestückenden Leiterplatten 120. Dem Leiterplattentyp 122 sind einer oder mehrere Bauelementetypen 160 zugeordnet, von denen jeweils eines oder mehrere Bauelemente 155 zu bestücken sind.

Dem Leiterplattentyp 122 können noch weitere Informationen zugeordnet sein. Beispielsweise können eine Anzahl 220 von Bauelementetypen 160, die auf jeder Leiterplatte 120 bestückt werden sollen, eine Anzahl 225 von Bestückpositionen einer Leiterplatte 120 oder eine Produktionszeit 230 für eine Leiterplatte 120 angegeben sein. Die Anzahl 225 der Bestückpositionen entspricht üblicherweise der Anzahl der auf einer Leiterplatte 120 des Leiterplattentyps 122 zu bestückenden Bauelemente 155, gleich welchen Bauelementetyps 160.

Einem Auftrag 210 kann eine Priorität 235 zugeordnet sein, die angibt, mit welcher Dringlichkeit der Auftrag 210 auszuführen ist.

Eine Vielzahl Aufträge 210 liegt für einen ersten Planungszeitraum 240 vor, der in mehrere zweite Planungszeiträume 245 unterteilt ist. Der erste Planungszeitraum kann beispielsweise mehrere Monaten oder ein Jahr umfassen. Der zweite Planungszeitraum kann beispielsweise einen oder mehrere Tage oder eine oder wenige Wochen umfassen. Üblicherweise sind alle zweiten Planungszeiträume 245 gleich lang und grenzen bevorzugterweise unmittelbar aneinander an. In einer Ausführungsform umfasst der erste Planungszeitraum 240 mindestens 20 zweite Planungszeiträume 245.

Jedem zweiten Planungszeitraum 245 sind einer oder mehrere Aufträge 210 zugeordnet. Kann ein Auftrag 210 nicht in dem ihm zugeordneten zweiten Planungszeitraum 245 fertig gestellt werden, so kann er unter Umständen in einen nachfolgenden zweiten Planungszeitraum 245 verschoben werden. Dabei kann die Priorität des Auftrags 210 angehoben werden.

Das Verfahren 200 bestimmt für die Aufträge des ersten Planungszeitraums 240 eine Festrüstung 165 und für jeden zweiten Planungszeitraum 245 wenigstens eine Variantenrüstung 170. Um die Festrüstung 165 möglichst so zu bestimmen, dass die Variantenrüstungen 170 im Rüstbetrieb der Bestückungslinie 110 gut handhabbar sind, wird die Festrüstung 165 bezüglich einer gewichteten Kombination eines Produktionsvolumens und einer Auftragszahl optimiert.

Die Auftragszahl entspricht der Anzahl Aufträge 210, die mittels der Festrüstung 165 bestückt werden können. Das Produktionsvolumen entspricht der Summe der Produktionszeiten der Aufträge 210, die in die Auftragszahl einfließen.

Eine gewichtete Kombination kann beispielsweise eine Summe aus dem Produkt aus der Auftragszahl mit einem ersten Gewichtungsfaktor und einem Produkt aus dem Produktionsvolumen und einem zweiten Gewichtungsfaktor umfassen. Wird einer der Gewichtungsfaktoren erhöht, so wird der andere bevorzugterweise gleichzeitig verringert. Die Summe der Faktoren kann beispielsweise stets eine vorbestimmte Konstante ergeben, insbesondere 1.

Die Zuordnung von Leiterplattentypen 122 zur Festrüstung 165 wird vorzugsweise mit Methoden der der Linearen Optimierung optimiert. Die Lineare Optimierung ist die Grundlage der Lösungsverfahren der (Gemischt) Ganzzahligen Linearen Optimierung (MIP: Mixed Integer Programming). Für die Bearbeitung konkreter Probleme mittels MIP steht eine Reihe guter kommerzieller Standard-Solver (Ilog, Gurobi, Xpress) bereit, die in der Praxis weit verbreitet und bewährt sind. Dabei wird als Optimierungskriterium die gewichtete Kombination des Produktionsvolumens und der Auftragszahl angegeben.

Anschließend wird bewertet, vorzugsweise mittels Simulation, welche Auswirkungen die bestimmte Festrüstung 165 auf den Betrieb der Bestückungslinie 110 hat. Dazu werden für jeden zweiten Planungszeitraum 245 Variantenrüstungen 170 gebildet, um die Aufträge 210, deren Produktionszeit 230 in den jeweiligen zweiten Planungszeitraum 245 fällt, auf der Bestückungslinie 110 bearbeiten zu können.

Wie unten mit Bezug auf Figur 3 noch genauer beschrieben wird, wird dann bevorzugterweise eine Abfolge von Festrüstungen 165 und/oder Variantenrüstungen 170 an der Bestückungslinie 110 bestimmt. Danach wird ein Kriterium bestimmt, das die Qualitäten der bestimmten Abfolgen aller zweiten Planungszeiträume 245 umfasst. Das Kriterium kann beispielsweise die Minimierung einer Stillstandszeit der Bestückungslinie 110 umfassen. Andere oder kombinierte Kriterien sind ebenfalls möglich, wie oben beschrieben ist. Das Kriterium ist bevorzugterweise von der oder den bestimmten Festrüstungen 165 abhängig, deren Bildung von der Gewichtung der Kombination des Produktionsvolumens und der Auftragszahl abhängig ist. Um ein optimiertes Kriterium bereitzustellen, können die oben genannten Schritte mit einer veränderten Gewichtung der Kombination des Produktionsvolumens und der Auftragszahl wiederholt werden. Bevorzugterweise werden die Schritte möglichst häufig mit unterschiedlichen Gewichtungen durchgeführt, um diejenige Gewichtung zu finden, die ein optimiertes Bilden von Variantenrüstungen 170 erlaubt.

Anschließend können Leiterplatten 120 mittels einer Rüstung 165, 170 bestückt werden, die auf der Basis der optimierten Gewichtung bestimmt wurde.

Ferner kann für einen weiteren ersten Planungszeitraum 240, der sich an den oben genannten ersten Planungszeitraum 240 anschließt, die bestimmte Gewichtung für die Bestimmung von Festrüstungen 165 übernommen werden. Die Gewichtung kann die tatsächlichen Verhältnisse an der Bestückungslinie 110 widerspiegeln, sodass sie eine verbesserte Bildung von Variantenrüstungen 170 in den zweiten Planungszeiträumen 145 des weiteren ersten Planungszeitraums 240 erlaubt.

Figur 3 zeigt eine exemplarische Abfolge 300 von Rüstungen 165, 170 an einer Bestückungslinie 110 des Bestückungssystems 100 von Figur 1. Innerhalb eines exemplarischen zweiten Planungszeitraums 245 werden nacheinander die Rüstungen A-B-C-B-D gerüstet. Dabei sind die Rüstungen A und D Festrüstungen 165 und die Rüstungen B und C sind Variantenrüstungen 170.

Während die Festrüstung A an der Bestückungslinie 110 gerüstet ist, können Rüsttische 140 mit der Variantenrüstung B aufgerüstet werden. Sind alle Leiterplatten 120, die mittels der Festrüstung 165 bestückt werden können, durch die Bestückungslinie 110 gelaufen, so erfolgt ein Rüstwechsel auf die Variantenrüstung B. Während mittels der Variantenrüstung B bestückt wird, kann die Variantenrüstung C vorbereitet werden. Sind ausreichend Rüsttische 140 vorhanden, so kann mit dem Realisieren der Variantenrüstung C begonnen werden, während noch die Festrüstung A an der Bestückungslinie 110 bereitgestellt ist.

In der beschriebenen Weise werden anschließend Rüstwechsel zur Variantenrüstung B und dann zur Festrüstung D durchgeführt. Bevorzugterweise wird eine Festrüstung A oder D in der Reihenfolge 300 zwischen zwei Variantenrüstungen B oder C eingefügt, wenn das Realisieren der Rüstung der zeitlich späteren Variantenrüstung B oder C Gefahr läuft, mehr Zeit in Anspruch zu nehmen, als die Produktionsdauer mittels der zeitlich früheren Variantenrüstung B oder C beträgt. Die genauen Konsequenzen der Abfolge 300 bezüglich der bestimmten Festrüstungen A und D und der bestimmten Variantenrüstungen B und C können auf unterschiedliche Weisen quantifiziert werden. Zur Bestimmung eines Kriteriums, das die Qualität der Abfolge 300 eines oder mehrerer zweiter Planungszeiträume 245 reflektiert, wird auf die Beschreibung von Figur 2 verwiesen.

Obwohl die Erfindung im Detail durch das bevorzugte Ausführungsbeispiel näher illustriert und beschrieben wurde, ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren (200) zum Bestücken von Leiterplatten (120)
- mittels einer Bestückungslinie (110), an der eine Rüstung (165, 170) bereitgestellt ist;
- wobei der Rüstung (165, 170) eine Rüstfamilie (175, 180) zugeordnet ist, die mehrere Leiterplattentypen (122) umfasst;
- wobei der Rüstung (165, 170) Bauelementetypen (160) zugeordnet sind,
- sodass eine Leiterplatte (120) eines Leiterplattentyps (122) einer Rüstfamilie (175, 180) mittels Bauelementen (155) der Bauelementetypen (160) der Rüstung (165, 170) bestückt werden kann;
- wobei ein erster Planungszeitraum (240) vorgegeben ist, der in mehrere zweite Planungszeiträume (245) aufgeteilt ist;
- wobei jede Rüstung (165, 170) durch Bereitstellen von Vorräten von Bauelementen (155) der zugeordneten Bauelementetypen (160) auf einem oder mehreren Rüsttischen (140) realisiert wird,
- wobei die Zahl der verfügbaren Rüsttische (140) begrenzt ist;
- wobei die Rüstungen in Festrüstungen (165) und Variantenrüstungen (170) unterschieden werden;
- wobei eine Festrüstung (165) über den ersten Planungszeitraum (240) unverändert auf einem oder mehreren Rüsttischen (140) realisiert bleibt; und eine Variantenrüstung (180) innerhalb eines zweiten Planungszeitraums (245) nur vorübergehend an einem oder mehreren Rüsttischen (140) realisiert wird;
wobei das Verfahren folgende Schritte umfasst:
a) Erfassen von Aufträgen (210), jeweils zur Bestückung einer Stückzahl (215) von Leiterplatten (120) eines Leiterplattentyps (122) mit Bauelementen (155) zugeordneter Bauelementetypen (160) in einem vorbestimmten zweiten Planungszeitraum (245);
b) Zuordnen von Bauelementetypen (160) zu Festrüstungen (165) auf der Basis aller Aufträge,
wobei einer Festrüstung (165) eine Festrüstungs-Rüstfamilie (175) zugeordnet ist, die Leiterplatten (122) umfasst, deren zugeordneten Leiterplatten (120) mit Bauelementen (155) von Bauelementetypen (160) der zugeordneten Festrüstung (165) vollständig bestückt werden können;
c) Optimieren der Zuordnung bezüglich der Maximierung einer gewichteten Kombination eines Produktionsvolumens und einer Auftragszahl,
wobei die Auftragszahl der Anzahl Aufträge (210), die mittels der Festrüstung (165) bestückt werden können, entspricht,
wobei das Produktionsvolumen der Summe der Produktionszeiten der Aufträge (210), die in die Auftragszahl einfließen, entspricht, und
wobei die gewichtete Kombination eine Summe aus dem Produkt aus der Auftragszahl mit einem ersten Gewichtungsfaktor und einem Produkt aus dem Produktionsvolumen und einem zweiten Gewichtungsfaktor umfasst;
d) Für jeden zweiten Planungszeitraum (245):
- Zuordnen von Bauelementetypen (160) zu Variantenrüstungen (170) auf der Basis von Aufträgen (210) des jeweiligen zweiten Planungszeitraums (245);
- Bestimmen einer Abfolge (300), in der Festrüstungen (165) oder Variantenrüstungen (170) an der Bestückungslinie (110) gerüstet werden sollen, um jeweils einen Auftrag (210) zu bearbeiten;
e) Bestimmen eines Kriteriums, das die Qualitäten der bestimmten Abfolgen (300) aller zweiten Planungszeiträume (245) umfasst,
wobei das Kriterium auf den bestimmten Abfolgen (300) aller zweiten Planungszeiträume (245) basiert und eine Minimierung einer Stillstandszeit, einer Anzahl von Variantenrüstungen, einer Anzahl Rüstvorgänge, einer Anzahl Rüstwechsel oder eine gewichtete Kombination der genannten Faktoren umfasst;
f) Bestimmen einer optimierten Gewichtung, bei der das Kriterium optimiert ist durch
Wiederholen der Schritte b.) bis e.) unter einer veränderten Gewichtung der Kombination,
wobei die Schritte b.) bis e.) wiederholt werden, bis das Kriterium eine vorbestimmte Qualität erreicht hat oder eine vorbestimmte Bearbeitungszeit abgelaufen ist;
g) Bestücken von Leiterplatten (120) mittels einer Rüstung (165, 170), die auf der Basis der optimierten Gewichtung bestimmt wurde.

2. Verfahren (200) nach Anspruch 1, wobei das Produktionsvolumen zur Verringerung der Stillstandszeiten verstärkt gewichtet wird.

3. Verfahren (200) nach Anspruch 2, wobei das Produktionsvolumen zur Verringerung der Anzahl Variantenrüstungen verringert gewichtet wird.

4. Verfahren (200) nach einem der vorangehenden Ansprüche, wobei die gewichtete Kombination zusätzlich einen Bestandteil für die Summe der Anzahl Bauelementetypen (220), die Festrüstungen (170) zugeordnet sind, multipliziert mit der Auftragszahl, umfasst.

5. Verfahren (200) nach einem der vorangehenden Ansprüche, wobei Schritt c.) mittels eines Gemischt Ganzzahligen Programms erfolgt.

6. Computerprogrammprodukt mit Programmcodemitteln zur Durchführung des Verfahrens (200) nach einem der vorangehenden Ansprüche zum Bestücken von Leiterplatten (120)
- mittels einer Bestückungslinie (110), an der eine Rüstung (165, 170) bereitgestellt ist;
- wobei der Rüstung (165, 170) eine Rüstfamilie (175, 180) zugeordnet ist, die mehrere Leiterplattentypen (122) umfasst;
- wobei der Rüstung (165, 170) Bauelementetypen (160) zugeordnet sind,
- sodass eine Leiterplatte (120) eines Leiterplattentyps (122) einer Rüstfamilie (175, 180) mittels Bauelementen (155) der Bauelementetypen (160) der Rüstung (165, 170) bestückt werden kann;
- wobei ein erster Planungszeitraum (240) vorgegeben ist, der in mehrere zweite Planungszeiträume (245) aufgeteilt ist;
- wobei jede Rüstung (165, 170) durch Bereitstellen von Vorräten von Bauelementen (155) der zugeordneten Bauelementetypen (160) auf einem oder mehreren Rüsttischen (140) realisiert werden kann;
- wobei die Rüstungen in Festrüstungen (165) und Variantenrüstungen (170) unterschieden werden,
- wobei eine Festrüstung (165) dazu eingerichtet ist, über den ersten Planungszeitraum (240) unverändert auf einem oder mehreren Rüsttischen (140) realisiert zu bleiben,
- und eine Variantenrüstung (180) dazu eingerichtet ist, innerhalb eines zweiten Planungszeitraums (245) nur vorübergehend an einem oder mehreren Rüsttischen (140) realisiert zu werden,
- wenn das Computerprogrammprodukt auf einer Verarbeitungseinrichtung (115) abläuft.

7. System (100) zur Bestückung von Leiterplatten (120), umfassend eine Bestückungslinie (110) und eine Verarbeitungseinrichtung (115),
- wobei an der Bestückungslinie (110) eine Rüstung (165, 170) bereitgestellt ist;
- wobei der Rüstung (165, 170) eine Rüstfamilie (175, 180) zugeordnet ist, die mehrere Leiterplattentypen (122) umfasst;
- wobei der Rüstung (165, 170) Bauelementetypen (160) zugeordnet sind,
- sodass eine Leiterplatte (120) eines Leiterplattentyps (122) einer Rüstfamilie (175, 180) mittels Bauelementen (155) der Bauelementetypen (160) der Rüstung (165, 170) bestückt werden kann;
- wobei ein erster Planungszeitraum (240) vorgegeben ist, der in mehrere zweite Planungszeiträume (245) aufgeteilt ist;
- wobei jede Rüstung (165, 170) durch Bereitstellen von Vorräten von Bauelementen (155) der zugeordneten Bauelementetypen (160) auf einem oder mehreren Rüsttischen (140) realisiert werden kann;
- wobei die Rüstungen in Festrüstungen (165) und Variantenrüstungen (170) unterschieden werden,
- wobei eine Festrüstung (165) dazu eingerichtet ist, über den ersten Planungszeitraum (240) unverändert auf einem oder mehreren Rüsttischen (140) realisiert zu bleiben,
- und eine Variantenrüstung (180) dazu eingerichtet ist, innerhalb eines zweiten Planungszeitraums (245) nur vorübergehend an einem oder mehreren Rüsttischen (140) realisiert zu werden;
- wobei die Verarbeitungseinrichtung (115) zur Durchführung des Verfahrens (200) nach einem der Ansprüche 1 bis 5 ausgebildet ist.

## Claims

1. Method (200) for populating printed circuit boards (120)
- by means of a pick-and-place line (110), at which a set-up (165, 170) is made available;
- wherein a set-up family (175, 180) that comprises a plurality of printed circuit board types (122) is associated with the set-up (165, 170);
- wherein component types (160) are associated with the set-up (165, 170),
- so that a printed circuit board (120) of a printed circuit board type (122) of a set-up family (175, 180) can be populated by means of components (155) of the component types (160) of the set-up (165, 170);
- wherein a first planning period (240) is specified, and is divided into a plurality of second planning periods (245) ;
- wherein each set-up (165, 170) is implemented at one or a plurality of setting-up tables (140) through the provision of stocks of components (155) of the associated component types (160),
- wherein the number of available setting-up tables (140) is limited;
- wherein the set-ups are divided into fixed set-ups (165) and variant set-ups (170);
- wherein a fixed set-up (165) remains implemented unchanged on one or a plurality of setting-up tables (140) during the first planning period (240);
and a variant set-up (180) is implemented only temporarily at one or a plurality of setting-up tables (140) during a second planning period (245);
wherein the method comprises the following steps:
a) registration of orders (210), each for populating a piece count (215) of printed circuit boards (120) of a printed circuit board type (122) with components (155) associated with component types (160) in a predetermined second planning period (245);
b) association of component types (160) with fixed set-ups (165) on the basis of all orders,
wherein a fixed set-up family (175) is associated with a fixed set-up (165), which fixed set-up family comprises the printed circuit boards (122) whose associated printed circuit boards (120) can be fully populated with components (155) of component types (160) of the associated fixed set-up (165);
c) optimization of the association with reference to the maximization of a weighted combination of a production volume and a number of orders,
wherein the number of orders corresponds to the number of orders (210) that can be populated by means of the fixed set-up (165), wherein the production volume corresponds to the total of the production times of the orders (210) that are included in the number of orders, and wherein the weighted combination comprises a total of the product of the number of orders with a first weighting factor and a product of the production volume and a second weighting factor;
d) for each second planning period (245):
- association of component types (160) with variant set-ups (170) on the basis of orders (210) of the respective second planning period (245);
- determination of a sequence (300) in which fixed set-ups (165) or variant set-ups (170) should be set up at the pick-and-place line (110) in order in each case to process an order (210);
e) determination of a criterion that comprises the qualities of the determined sequences (300) of all the second planning periods (245),
wherein the criterion is based on the determined sequences (300) of all the second planning periods (245), and comprises a minimization of a downtime, of a number of variant set-ups, of a number of setting-up procedures, of a number of set-up changes or a weighted combination of the stated factors;
f) determination of an optimized weighting at which the criterion is optimized by
repetition of steps b.) to e.) with a changed weighting of the combination,
wherein the steps b.) to e.) are repeated until the criterion has achieved a predetermined quality, or until a predetermined processing time has elapsed;
g) population of printed circuit boards (120) by means of a set-up (165, 170) that has been determined on the basis of the optimized weighting.

2. Method (200) according to Claim 1, wherein the production volume is given extra weighting in order to reduce the downtimes.

3. Method (200) according to Claim 2, wherein the production volume is given reduced weighting in order to reduce the number of variant set-ups.

4. Method (200) according to one of the previous claims, wherein the weighted combination additionally comprises a constituent for the total of the number of component types, (220) that are associated with fixed set-ups (170), multiplied by the number of orders.

5. Method (200) according to one of the previous claims, wherein step c.) is performed by means of a mixed integer program.

6. Computer program product with program code means for carrying out the method (200) according to one of the previous claims for populating printed circuit boards (120)
- by means of a pick-and-place line (110), at which a set-up (165, 170) is made available;
- wherein a set-up family (175, 180) that comprises a plurality of printed circuit board types (122) is associated with the set-up (165, 170);
- wherein component types (160) are associated with the set-up (165, 170),
- so that a printed circuit board (120) of a printed circuit board type (122) of a set-up family (175, 180) can be populated by means of components (155) of the component types (160) of the set-up (165, 170);
- wherein a first planning period (240) is specified, and is divided into a plurality of second planning periods (245);
- wherein each set-up (165, 170) can be implemented at one or a plurality of setting-up tables (140) through the provision of stocks of components (155) of the associated component types (160);
- wherein the set-ups are divided into fixed set-ups (165) and variant set-ups (170),
- wherein a fixed set-up (165) is configured to remain implemented unchanged on one or a plurality of setting-up tables (140) during the first planning period (240),
- and a variant set-up (180) is configured to be implemented only temporarily at one or a plurality of setting-up tables (140) during a second planning period (245),
- when the computer program product runs on a processing apparatus (115).

7. System (100) for populating printed circuit boards (120), comprising a pick-and-place line (110) and a processing apparatus (115),
- wherein a set-up (165, 170) is made available at the pick-and-place line (110);
- wherein a set-up family (175, 180) that comprises a plurality of printed circuit board types (122) is associated with the set-up (165, 170);
- wherein component types (160) are associated with the set-up (165, 170),
- so that a printed circuit board (120) of a printed circuit board type (122) of a set-up family (175, 180) can be populated by means of components (155) of the component types (160) of the set-up (165, 170);
- wherein a first planning period (240) is specified, and is divided into a plurality of second planning periods (245) ;
- wherein each set-up (165, 170) can be implemented at one or a plurality of setting-up tables (140) through the provision of stocks of components (155) of the associated component types (160);
- wherein the set-ups are divided into fixed set-ups (165) and variant set-ups (170),
- wherein a fixed set-up (165) is configured to remain implemented unchanged on one or a plurality of setting-up tables (140) during the first planning period (240),
- and a variant set-up (180) is configured to be implemented only temporarily at one or a plurality of setting-up tables (140) during a second planning period (245) ;
- wherein the processing apparatus (115) is configured for carrying out the method (200) according to one of Claims 1 to 5.

## Revendications

1. Procédé (200) de placement de composants sur des plaques à circuit imprimé (120)
- au moyen d'une ligne de montage (110), à laquelle un équipement (165, 170) est fourni;
- dans lequel une famille d'équipements (175, 180) qui comprend plusieurs types de plaques à circuit imprimé (122) est associée à l'équipement (165, 170);
- dans lequel des types de composant (160) sont affectés à l'équipement (165, 170),
- de telle sorte qu'une plaque à circuit imprimé (120) d'un type de plaque à circuit imprimé (122) d'une famille d'équipements (175, 180) peut être équipée avec des composants (155) des types de composants (160) de l'équipement (165, 170);
- dans lequel une première période de planification (240) est prédéterminée, laquelle est divisée en plusieurs secondes périodes de planification (245);
- dans lequel chaque équipement (165, 170) est mis en place sur une ou plusieurs tables de report en pourvoyant à des réserves de composants (155) des types de composant (160) affectés,
- dans lequel le nombre des tables de report disponibles (140) est limité;
- dans lequel dans les équipements, on distingue entre des équipements fixes (165) et des variantes d'équipement (170);
- dans lequel un équipement fixe (165) demeure mis en oeuvre de façon invariable dans une période de planification sur une ou plusieurs tables de report (140); et une variante d'équipement (180) est mise en oeuvre dans une seconde période de planification (245) uniquement temporairement sur une ou plusieurs tables de report;
le procédé comprenant les étapes suivantes :
a) détection des commandes (210) respectives pour équiper un nombre de pièces (215) de plaques à circuit imprimé (120) d'un type de plaque à circuit imprimé (122) avec des composants (155) de types de composants affectés (160) dans une seconde période de planification (245) prédéterminée;
b) affectation de types de composant (160) à des équipements fixes (165) sur la base de toutes les commandes,
une famille d'équipements fixes (175) étant affectée à un équipement fixe (165), laquelle famille comprend des plaques à circuit imprimé (120) dont les plaques à circuit imprimé affectées (120) peuvent être entièrement équipées avec des composants (155) des types de composant (160) de l'équipement fixe affecté (165);
c) optimisation de l'affectation concernant la maximisation d'une combinaison pondérée d'un volume de production et d'un nombre de commandes,
le nombre de commandes correspondant au nombre de commandes (210) qui peuvent être équipées au moyen de l'équipement fixe (165),
le volume de production correspondant à la somme des durées de fabrication des commandes (210) prises en compte dans le nombre de commandes, et
la combinaison pondérée comprenant une somme d'un produit du nombre de commandes par un premier facteur de pondération et d'un produit du volume de production par un second facteur de pondération;
d) pour chaque seconde période de planification (245) :
- affectation de types de composant (160) à des variantes d'équipement (170) sur la base des commandes (210) de la seconde période de planification (245) respective;
- détermination d'une séquence (300), dans laquelle des équipements fixes (165) ou des variantes d'équipement (170) doivent être montés sur la ligne de montage (110) pour traiter respectivement une commande (210);
e) détermination d'un critère qui comprend les qualités des séquences déterminées (300) de toutes les deux périodes de planification (245),
dans lequel le critère est basé sur les séquences déterminées (300) des deux périodes de planification (245), et comprend une minimisation d'un temps d'arrêt, d'un nombre de variantes d'équipement, d'un nombre d'opérations d'équipement, d'un nombre de changements d'équipement ou une combinaison pondérée des facteurs cités;
f) détermination d'une pondération optimisée, dans laquelle le critère est optimisé en répétant les étapes b) à e) dans une pondération modifiée de la combinaison,
dans laquelle les étapes b) à e) sont répétées jusqu'à ce que le critère atteigne une qualité prédéterminée ou qu'un temps de traitement prédéterminé soit écoulé;
g) montage d'un équipement (165, 170) sur les plaques à circuit imprimé (120) qui a été déterminé sur la base de la pondération optimisée.

2. Procédé (200) selon la revendication 1, dans lequel le volume de production est davantage pondéré pour diminuer les temps d'arrêt.

3. Procédé (200) selon la revendication 2, dans lequel le volume de production est pondéré de façon atténuée pour diminuer le nombre de variantes d'équipement.

4. Procédé (200) selon l'une des revendications précédentes, dans lequel la combinaison pondérée comprend en outre une composante pour la somme du nombre de types de composant (220) qui sont affectés aux équipements fixes (170), multipliée par le nombre de commandes.

5. Procédé (200) selon l'une des revendications précédentes, dans lequel l'étape c) est exécutée au moyen d'un programme mixte en nombres entiers.

6. Produit de programme informatique comportant des moyens de code de programme pour exécuter le procédé (200) de placement de composants sur des plaques à circuit imprimé (120) selon l'une des revendications précédentes
- au moyen d'une ligne de montage (110), à laquelle un équipement (165, 170) est fourni;
- dans lequel une famille d'équipements (175, 180) qui comprend plusieurs types de plaques à circuit imprimé (122) est affectée à l'équipement (165, 170);
- dans lequel des types de composant (160) sont affectés à l'équipement (165, 170),
- de telle sorte qu'une plaque à circuit imprimé (120) d'un type de plaque à circuit imprimé (122) d'une famille d'équipements (175, 180) peut être équipée avec des composants (155) des types de composants (160) de l'équipement (165, 170);
- dans lequel une première période de planification (240) est prédéterminée, laquelle est divisée en plusieurs secondes périodes de planification (245);
- dans lequel chaque équipement (165, 170) est mis en oeuvre sur une ou plusieurs tables de report (140) en pourvoyant à des réserves de composants (155) des types de composant (160) affectés;
- dans lequel les équipements comportent des équipements fixes (165) et des variantes d'équipement (170),
- dans lequel un équipement fixe (165) est conçu pour être mis en oeuvre de façon invariable dans la première période de planification (240) sur une ou plusieurs tables de report (140),
et une variante d'équipement (180) est conçue pour être mise en oeuvre dans une seconde période de planification (245) uniquement temporairement sur une ou plusieurs tables de report,
lorsque le produit de programme informatique est exécuté sur un moyen de traitement (115).

7. Système (100) de placement de composants sur des plaques à circuit imprimé (120), comprenant une ligne de montage (110) et un moyen de traitement informatique (115),
- dans lequel un équipement (165, 170) est fourni à la ligne de montage (110);
- dans lequel une famille d'équipements (175, 180) qui comprend plusieurs types de plaques à circuit imprimé (122) est affectée à l'équipement (165, 170);
- dans lequel des types de composant (160) sont affectés à l'équipement (165, 170),
- de telle sorte qu'une plaque à circuit imprimé (120) d'un type de plaque à circuit imprimé (122) d'une famille d'équipements peut être équipée avec des composants (155) des types de composants (160) de l'équipement (165, 170);
- dans lequel une première période de planification (240) est prédéterminée, laquelle est divisée en plusieurs secondes périodes de planification (245);
- dans lequel chaque équipement (165, 170) peut être mis en oeuvre sur une ou plusieurs tables de report (140) en pourvoyant à des réserves de composants (155) des types de composant (160) affectés;
- dans lequel les équipements comportent des équipements fixes (165) et des variantes d'équipement (170),
- dans lequel un équipement fixe (165) est conçu pour être mis en oeuvre de façon invariable dans la première période de planification (240) sur une ou plusieurs tables de report (140),
- et une variante d'équipement (180) est conçue pour être mise en oeuvre dans une seconde période de planification (245) uniquement temporairement sur une ou plusieurs tables de report;
dans lequel le moyen de traitement (115) est conçu pour exécuter le procédé (200) selon l'une des revendications 1 à 5.
